Europäisches Patentamt

European Patent Office

Office européen des brevets

(19)

(11) Veröffentlichungsnummer : **0 148 389**
**B1**

(12) # EUROPÄISCHE PATENTSCHRIFT

(45) Veröffentlichungstag der Patentschrift :
07.03.90

(51) Int. Cl.$^5$ : **H 03 J   7/02**, **H 04 N   5/50**

(21) Anmeldenummer : 84114292.0

(22) Anmeldetag : 27.11.84

(54) Abstimmsystem für einen Fernsehempfänger.

(30) Priorität : 27.12.83 DE 3347132

(43) Veröffentlichungstag der Anmeldung :
17.07.85 Patentblatt 85/29

(45) Bekanntmachung des Hinweises auf die Patenterteilung : 07.03.90 Patentblatt 90/10

(84) Benannte Vertragsstaaten :
AT BE CH DE FR GB IT LI LU NL SE

(56) Entgegenhaltungen :
DE—A— 2 854 852
FR—A— 1 412 209
US—A— 3 736 512
US—A— 4 334 323
NACHRICHTEN ELEKTRONIK, November 1979, Seiten 365-368, Heidelberg, DE; H. RINDERLE et al.:
"Integrierte Schaltkreise für Rundfunkempfänger mit
elektronischer Senderwahl"
IEEE TRANSACTIONS ON CONSUMER ELECTRO-
NICS, Band CE-27, Nr. 3, August 1981, Seiten 284-292,
IEEE, New York, US; G.K. LUNN et al.: "MONOMAX" -
An approach to the one-chip TV"

(73) Patentinhaber : Deutsche Thomson-Brandt GmbH
Hermann-Schwer-Strasse 3 Postfach 1307
D-7730 Villingen-Schwenningen (DE)

(72) Erfinder : Maier, Gerhard
Reutestrasse 19
D-7735 Dauchingen (DE)

EP 0 148 389 B1

**Beschreibung**

Die Erfindung geht aus von einem automatisch arbeitenden Abgleichsystem für den Tuner eines Fernsehempfangsgerätes mit einem von einem Phasenregelkreis abstimmbaren Tuneroszillator, bei welchem während des automatischen Abgleichs an den Antenneneingang eine Hilfsfrequenz angeschaltet ist und die einzelnen HF-Abstimmkreise des Tuners nacheinander auf eine maximale Ausgangsspannung abgeglichen werden, indem von einem Mikroprozessor gesteuert nacheinander in digitalen Schritten Abstimmspannungswerte an die in den HF-Abstimmkreisen befindlichen Kapazitätsdioden gelegt werden und die Erhöhung der Abstimmspannungswerte bei Erreichen eines durch eine Auswerteschaltung festgestellten Maximalwertes am Ausgang unterbrochen wird.

Eine derartige Abstimmeinheit ist z. B. in der DE-A-28 54 852 beschrieben, die mittels dreier Hilfsoszillatoren und diesen zugeordneten Analogspeichern unter Verwendung der PLL-Schaltung die Hochfrequenzkreise auf die gewünschte Empfangsfrequenz abstimmen. Bei dieser Abstimmeinheit wird auch dabei der Tunersozillator beim Abgleich herangezogen. Außerdem sind der Zahl der abzugleichenden Hochfrequenzkreise entsprechende Hilfsoszillatoren notwendig. Die Zahl der benötigten Hilfsoszillatoren und somit der Materialaufwand erhöht sich dann in besonderem Maße, wenn z. B. beim Abgleich eines Fernsehempfängers Band I, Band III und die Bänder IV und V abgeglichen werden sollen. Es besteht dabei die Gefahr von Mehrdeutigkeiten zwischen den Frequenzen des Tuneroszillators, der Hilfsoszillatoren und den Empfangsfrequenzen. Nachteilig für eine praktikable Realisierung der vorgeschlagenen Abstimmeinheit ist, daß die Erregerwicklungen der Hilfsoszillatoren mit den einzelnen Spulen in den Hochfrequenzkreisen unerwünschte Resonanzen und Bedämpfungen der Kreise hervorrufen können, die auch noch eine unkontrollierbare Verstimmung der Kreise verursachen, wenn die Hilfsoszillatoren nach erfolgtem Abgleich abgeschaltet sind. Außerdem sind Analogspeicher vorgesehen, die in zeitlichen Abständen nachgeladen werden müssen, um die optimalen Abstimmwerte zu erhalten. Aus diesen Gründen ist prinzipbedingt ein optimaler Abgleich des Empfangsgerätes nicht erreichbar. Außerdem werden durch das sich laufend wiederholende Nachstimmen Störungen auf dem Bildschirm oder im Lautsprecher sichtbar bzw. hörbar.

In der Zeitschrift « Nachrichten elektronik » Heft 11/79, Seiten 365-368 wird ein Abstimmverfahren für Rundfunkempfänger beschrieben, das ebenfalls zusätzliche Hilfskreise in den Hochfrequenzfiltern anwendet. Auch hier ergeben sich nachteilige Beeinflussungen der Kreise im Betrieb des abgeglichenen Empfängers. Wie auf Seite 367 linke und mittlere Spalte angegeben, wird die Genauigkeit der Abstimmungen durch Spezialbauteile nur in Form von exakt gepaarten Dioden erzielt. Auch dies erfordert einen nicht außer acht zu lassenden Aufwand.

Es ist auch ein Testsystem für einen Empfänger bekannt (US-A-3 736 512, welches im On-line-Betrieb die Eigenschaften der einzelnen Stufen des Empfängers wie z. B. Vorverstärker, Mischstufe, ZF-Verstärker überprüft. Bei Abweichungen von den Sollwerten, die optisch angezeigt werden, müssen diese vom Bedienenden des Empfängers korrigiert werden. Es handelt sich nicht um ein in sich geschlossenes Abgleichsystem, bei welchem HF-Filterkreise automatisch für jeden Empfangskanal optimal abgeglichen werden.

Der Erfindung liegt die Aufgabe zugrunde, ein Abgleichsystem zu schaffen, welches bei Anwahl eines Kanals vollkommen automatisch das Nachrichtenempfangsgerät abgleicht, in dem die HF-Filter auf optimale Werte gebracht werden. Diese Aufgabe wird durch die im Patentanspruch angegebene Erfindung gelöst.

Die Erfindung besitzt den Vorteil, daß durch die Ausnutzung des ohnehin im Nachrichtenempfangsgerät vorhandenen integrierten Zwischenfrequenzbausteins mit seiner typischen Verstärkung von 60 db selbst für kleinste Pegel der Hilfsoszillatorfrequenz eine exakte Auswertung der Meßspannung möglich ist. Es werden Kosten gespart bei höchster Empfindlichkeit des automatischen Abgleichs. Durch die niedrigen Pegel der Hilfsoszillatorfrequenz am Antenneneingang werden die Postvorschriften bezüglich Störstrahlung mit Sicherheit eingehalten.

Nachstehend soll an einem Ausführungsbeispiel das Wesentliche des angemeldeten automatischen Abgleichsystems mit Hilfe der Zeichnung beschrieben werden.

Fig. 1 zeigt die wesentlichen für das automatische Abgleichsystem erforderlichen Baugruppen in einem Blockschaltbild.

Fig. 2 bis 4 zeigen zur Erläuterung der Wirkungsweise der Schaltung nach Fig. 1 dienende Diagramme.

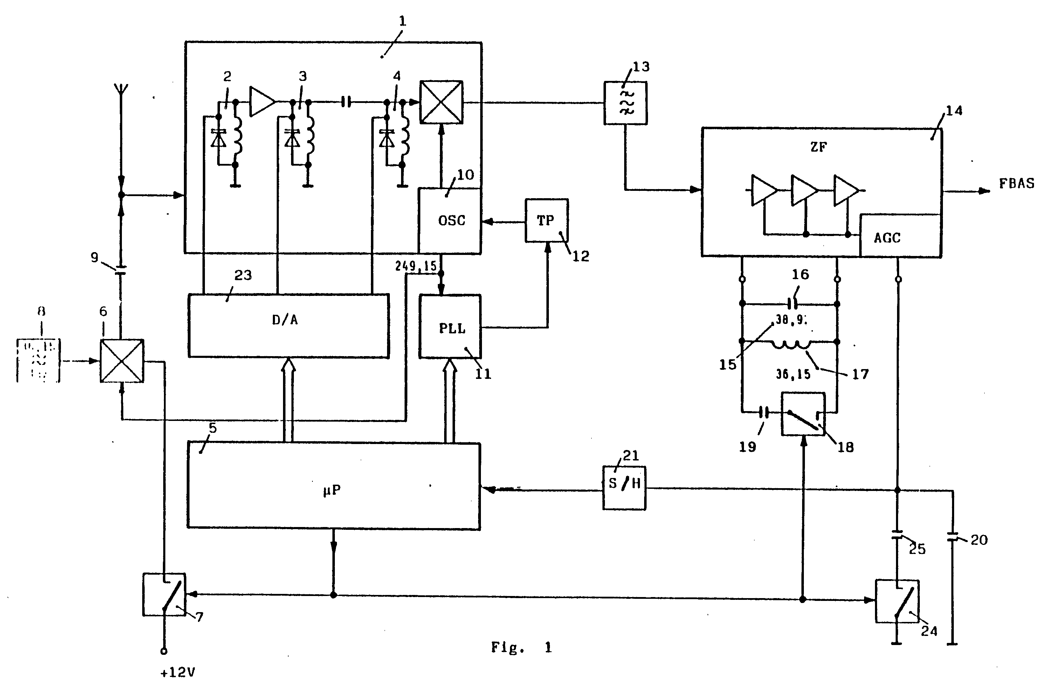

In Fig. 1 ist ein Tuner eines Nachrichtenempfangsgerätes mit 1 bezeichnet, dessen HF-Filterkreise 2, 3 und 4 automatisch abgeglichen werden sollen, indem an die in diesen befindlichen Kapazitätsdioden entsprechende Abstimmgleichspannungen angelegt werden. Beim automatischen Abgleich wird über einen Mikro-Prozessor 5 gesteuert eine Mischstufe 6 über eine Schaltstufe 7 eingeschaltet. Die Mischstufe erzeugt mit Hilfe eines Hilfsoszillators 8 eine Kennfrequenz, die über den Kondensator 9 an den Antenneneingang des Tuners 1 gelangt. Die von der Mischstufe 6 erzeugte Hilfsfrequenz ergibt sich aus der Oszillatorfrequenz $f_{osc}$ des Tuneroszillators, der von einer PLL-Schleife 11, 12 geregelt wird, und aus der Frequenz des Hilfsoszillators 8 als Differenzfrequenz aus $f_{osc}-f_{Hilf.}$ In Deutschland befindet sich diese Frequenz dann immer zwischen dem HF-Bild- und HF-Tonträger. So ergibt sich z. B. bei Anwahl des Kanals 10 im Band III des

Fernsehempfangsfrequenzbereichs eine Kennfrequenz von 213 MHz bei einer eingestellten Oszillatorfrequenz von 249,15 MHz des Tuneroszillators 1.

Die Kennfrequenz von 213 MHz ergibt zusammen mit der Oszillatorfrequenz von 249,15 MHz eine Zwischenfrequenz von 36,15 MHz am Ausgang des Tuners 1. Diese Zwischenfrequenz liegt in der Bandmitte des Zwischenfrequenzkanals und gelangt über einen Bandpass 13 auf den im Empfangsgerät vorhandenen Zwischenfrequenzbaustein 14. Dieser Baustein besitzt einen Synchron-Demodulator, für den die Referenzfrequenz an einem außen angeschalteten Referenzschwingkreis 15 erzeugt wird. Die Referenzschwingkreis besteht aus dem Kondensator 16 und der Spule 17 und ist für den normalen Empfangsfall auf 38,9 MHz den Bildzwischenfrequenzträger abgestimmt.

Während des automatischen Abgleichs wird vom Mikroprozessor 5 gesteuert der Referenzschwingkreis 15 auf die niedrigere Referenzfrequenz 36,15 MHz umgeschaltet, indem über die Schaltstufe 18 ein Kondensator 19 parallelgeschaltet wird.

Am AGC-Ausgang der Zwischenfrequenzstufe 14 wird am Kondensator 20 eine Meßspannung abgenommen, die über eine Sample-and-hold-Schaltung 21 gewandelt dem Mikroprozessor zugeführt wird, welcher solange die Abstimmspannung erhöht, bis ein Maximum der Meßspannung am AGC-Ausgang erreicht ist.

Der Mikroprozessor erhöht über den D/A-Wandler 23 die Abstimmspannung in Stufen bis die S/H-Schaltung einen optimalen Abgleich anzeigt. Für diesen optimalen Abgleich wird ein digitales Wort abgespeichert. Die übrigen Kreise werden auf die gleiche Weise vom Mikroprozessor 5 gesteuert nacheinander abgeglichen. Es ist notwendig während des automatischen Abgleichs die Zeitkonstante der automatischen Verstärkungsregelung zu verkleinern. Dies geschieht dadurch, daß über eine Schaltstufe 24 der für eine große Zeitkonstante maßgebliche Kondensator 25 abgeschaltet wird.

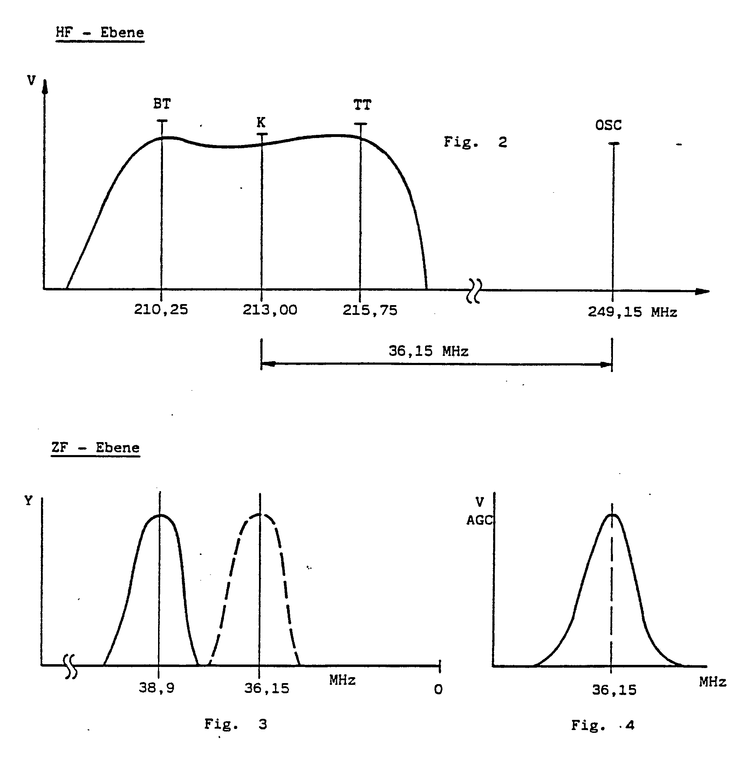

In Fig. 2 ist gezeigt, wie die Frequenzlage der erzeugten Kennfrequenz K entsteht. Dies sei am Beispiel des Kanals 10 erläutert.

Nach Anwahl des Kanals 10 stellt sich die Tuneroszillatorfrequenz auf 249,15 MHz ein. Der Bildträger des Empfangssignals liegt bei 210,25 MHz der Tonträger bei 215,75 MHz. Es wird eine Kennfrequenz K erzeugt, die zwischen Bildträger und Tonträger liegt und um 36,15 MHz niedriger als die eingestellte Oszillatorfrequenz ist. Diese Frequenz K stellt also die Differenz von $f_{osc}$ und 36,15 MHz dar.

In Fig. 3 ist gezeigt, wie der Referenzkreis 15 von seiner Resonanzfrequenz 38,9 MHz auf 36,15 MHz umgeschaltet wird.

In Fig. 4 ist der Verlauf der AGC-Spannung dargestellt, der ein genaues Abbild des Referenzkreises nach Fig. 3 ist.

## Patentansprüche

1. Automatisch arbeitendes Abgleichsystem für den Tuner eines Fernsehempfangsgerätes mit einem von einem Phasenregelkreis (PLL) (11) abstimmbaren Tuneroszillator (10), bei welchem während des automatischen Abgleichs an den Antenneneingang eine Hilfsfrequenz (8) angeschaltet ist und die einzelnen HF-Abstimmkreise (2, 3, 4) des Tuners (1) nacheinander auf eine maximale Ausgangsspannung abgeglichen werden, indem von einem Mikroprozessor (5) gesteuert nacheinander in digitalen Schritten Abstimmspannungswerte an die in den HF-Abstimmkreisen (2, 3, 4) befindlichen Kapazitätsdioden gelegt werden und die Erhöhung der Abstimmspannungswerte bei Erreichen eines durch eine Auswerteschaltung festgestellten Maximalwertes am Ausgang unterbrochen wird, dadurch gekennzeichnet, daß als Hilfsfrequenz (K) eine Frequenz gewählt wird, die sich aus der Differenz der eingestellten Tuneroszillatorfrequenz (OSC) und dem arithmetischen Mittel der ZF-Bildträgerfrequenz (BT) und der Tonträgerfrequenz (TT) ergibt, daß während des automatischen Abgleichvorgangs der im Gerät vorhandene ZF-Baustein (14) als Auswerteschaltung verwendet wird, indem das Ausgangssignal für die automatische Verstärkungsregelung (AGC) als Meßspannung einer Sample-and-Hold-Schaltung (21) zugeführt wird, die mit einem Eingang des Mikroprozessors (5) verbunden ist und daß der für den im ZF-Baustein (14) erforderliche Referenzschwingkreis (15) in seiner Resonanzfrequenz auf eine Frequenz umgeschaltet wird die dem arithmetischen Mittel von ZF-Bildträgerfrequenz (BT) und ZF-Tonträgerfrequenz (TT) entspricht.

2. Automatisch arbeitendes Abgleichsystem nach Anspruch 1, dadurch gekennzeichnet, daß während des Abgleichvorgangs ein an dem AGC-Ausgang des ZF-Bausteins (14) angeschalteter für die Zeitkonstante der automatischen Verstärkungsregelung maßgeblicher Kondensator (20, 25) vom Mikroprozessor (5) gesteuert auf einen kleineren Wert umgeschaltet wird.

## Claims

1. An adjustment system working automatically for the tuner of a television receiver having a tuner oscillator (10) which can be tuned by a phase-locked loop (PLL), wherein an auxiliary frequency (8) is connected to the aerial input during the automatic adjustment and the individual radio-frequency tuned circuits (2, 3, 4) of the tuner (1) are adjusted in succession to a maximum output voltage in that tuning voltage values are applied in succession, in digital steps, controlled by a microprocessor (5), to the capacitance diodes present in the radio-frequency tuned circuits (2, 3, 4), and the increase in the tuning voltage values is interrupted when a maximum value, detected by an evaluation circuit, is reached at the output, characterised in that a frequency which results from the difference between the set tuner oscillator frequency (OSC) and the arithmetical mean of the i.f. picture-carrier frequency (BT) and the sound-carrier frequency (TT) is selected as the auxiliary frequency (K), that during the automatic adjustment operation, the i.f. component (14) present in the set is used as an evaluation circuit in that the output signal for the automatic gain control (AGC) is fed as a measuring voltage to a sample-and-hold circuit (21) which is connected to an input of the microprocessor (5), and that the reference oscillatory circuit necessary in the i.f. component (14) is switched over, in its resonant frequency to a frequency which corresponds to the arithmetical mean of i.f. picture-carrier frequency (BT) and i.f. sound-carrier frequency (TT).

2. An adjustment system working automatically according to Claim 1, characterised in that, during the adjustment operation, a capacitor (20, 25), which is connected to the AGC output of the i.f. component (14) and is decisive for the time constant of the automatic gain control, is switched over to a lower value, controlled by the microprocessor (5).

## Revendications

1. Système de réglage à fonctionnement automatique pour le syntoniseur d'un appareil récepteur de télévision équipé d'un oscillateur de syntoniseur (10) accordable par un circuit de réglage de phase (PLL) (11), dans lequel, pendant le réglage automatique, on branche une fréquence auxiliaire (8) sur l'entrée antenne et on règle successivement les différents circuits d'accord HF (2, 3, 4) du syntoniseur (1) à une tension de sortie maximale, en appliquent en sauts numériques successifs, sous la commande d'un microprocesseur (5), des tensions d'accord aux diodes à capacité variable se trouvant dans les circuits d'accord HF (2, 3, 4) et en interrompant l'augmentation des tensions d'accord lorsqu'un circuit de mesure constate qu'une valeur maximale est atteinte à la sortie, caractérisé en ce que l'on choisit comme fréquence auxiliaire (K) une fréquence obtenue à partir de la fréquence de syntoniseur réglée (OSC) et de la moyenne arithmétique de la fréquence intermédiaire porteuse image (BT) et de la fréquence porteuse son (TT), que, pendant le processus de réglage automatique, le module de fréquence intermédiaire (14) se trouvant dans l'appareil est utilisé comme circuit de mesure, en envoyant le signal de sortie pour la commande automatique de gain (AGC) en tant que tension de mesure à un échantillonneur-bloqueur (21), relié à une entrée du microprocesseur (5), et que la fréquence de résonance du circuit oscillant de référence (15), nécessaire dans le module à fréquence intermédiaire (14), est commutée sur une fréquence qui correspond à la moyenne arithmétique de la fréquence intermédiaire porteuse image (BT) et de la fréquence intermédiaire porteuse son (TT).

2. Système de réglage à fonctionnement automatique selon la revendication 1, caractérisé en ce que, pendant le processus de réglage, un condensateur (20, 25) déterminant pour la constante de temps de la commande automatique de gain, branché sur la sortie AGC du module de fréquence intermédiaire (14), est commuté sur une valeur plus faible sous la commande du microprocesseur (5).

Fig. 1

EP 0 148 389 B1

<u>HF - Ebene</u>

Fig. 2

<u>ZF - Ebene</u>

Fig. 3

Fig. 4